# EUROPEAN PATENT SPECIFICATION

(11) **EP 3 220 493 B1**
(45) Date of publication and mention of the grant of the patent: **20.11.2019**
(21) Application number: 17158203.4
(22) Date of filing: 27.02.2017
(51) Int. Cl.: H01S 5/02, H01S 5/183, H01S 5/42, H01S 5/187, H01S 5/00, H01S 5/18, H01S 5/40

(54) **SURFACE-EMITTING LASER ARRAY AND LASER DEVICE**
OBERFLÄCHENEMITTIERENDER LASERANORDNUNG UND LASERGERÄT
RESEAU DES LASERS A EMISSION PAR LA SURFACE ET DISPOSITIF LASER

(30) Priority: 17.03.2016 JP 2016053601
(43) Date of publication of application: 20.09.2017
(73) Proprietor: Ricoh Company, Ltd., Tokyo 143-8555 (JP)
(72) Inventor: HANAOKA, Katsunari, Tokyo, 143-8555 (JP)
(74) Representative: J A Kemp LLP

(56) References cited:
- JP-A- 2009 277 781
- JP-A- 2012 023 107
- JP-B2- 5 151 317
- US-A1- 2013 157 397
- US-A1- 2013 230 070
- US-A1- 2014 133 510

## Description

### BACKGROUND

### Technical Field

Embodiments of the present disclosure relate to a surface-emitting laser array and a laser device.

### Background Art

Currently, the development of vertical-cavity surface-emitting laser (VCSEL) arrays are actively performed. The VCSEL arrays emit light in a direction vertical to a substrate, and are more cost effective, power saving, compact, suitable-for-two-dimensional-devices, and more sophisticated than surface-emitting semiconductor laser devices that emit light in a direction parallel to a substrate. For these reasons, the VCSEL arrays are applied to various kinds of fields such as of printers, optical disks, spark plugs for engines of a solid laser.

The VCSEL arrays have a semiconducting multilayer film (semiconducting distributed Bragg reflector (DBR)). However, such semiconducting multilayer films contains 90% or more aluminum, and is susceptible to oxidization due to moisture or the like. When a semiconducting multilayer film is oxidized, layers may be separated from each other due to an increase in volume. In some cases, such separation affects the performance of a VCSEL array.

In order to handle the above circumstances, a technology is developed that prevents a semiconducting multilayer film from being oxidized to improve the reliability of VCSEL arrays (see, for example, JP-2007-173513-A). JP-2007-173513-A relates to a technology in which circumferential trenches are formed at outer edges of a pad-forming area to isolate chips from each other and the sides and surfaces of a semiconducting multilayer film that are exposed due to the circumferential trenches are covered by an interlayer insulator film. Accordingly, intrusion of moisture from outside can be prevented, and the semiconducting multilayer film can be prevented from being oxidized.

However, the outermost edges of a chip are susceptible to physical shock in a manufacturing process such as a chip separating step and a chip conveying step, and when microcracks are developed on the surface of an interlayer insulator film due to such shock, moisture may intrude through such microcracks and the performance of a VCSEL array may be affected.

US 2013/230070 A1 (SATO SHUNICHI [JP] ET AL) 5 September 2013, discloses background information.

US 2013/157397 A1 (SHOUJI HIROYOSHI [JP] ET AL) 20 June 2013, discloses background information.

JP 2009 277781 A (RICOH KK) 26 November 2009, discloses background information.

US 2014/133510 A1 (SATO SHUNICHI [JP]) 15 May 2014, discloses background information.

JP5151317A discloses a VCSEL-array with a layered structure with an additional separation extending until the lower BDR-mirror.

### SUMMARY

According to the invention, there is provided a surface-emitting laser as set out in claim 1.

According to an embodiment of the invention, there is provided a laser device as set out in claim 6. Further embodiments are defined in the dependent claims.

### BRIEF DESCRIPTION OF THE DRAWINGS

A more complete appreciation of exemplary embodiments and the many attendant advantages thereof will be readily obtained as the same becomes better understood by reference to the following detailed description when considered in connection with the accompanying drawings.
FIG. 1 is a plan view and A-A' sectional view of a surface-emitting laser array according to a first embodiment of the present disclosure.
FIG. 2 is a schematic diagram of a surface-emitting laser array according to the first embodiment of the present disclosure.
FIG. 3 is a schematic diagram of a manufacturing process of a surface-emitting laser array, more specifically, illustrating a step of forming a layered product on a substrate, according to the first embodiment of the present disclosure.
FIG. 4 is a schematic diagram of a manufacturing process of a surface-emitting laser array, more specifically, illustrating a step of oxidizing a layered product to form an oxidized area and non-oxidized area, according to the first embodiment of the present disclosure.
FIG. 5 is a schematic diagram of a manufacturing process of a surface-emitting laser array, more specifically, illustrating a step of forming a chip separation trench and a second trench, according to the first embodiment of the present disclosure.
FIG. 6 is a schematic diagram of a manufacturing process of a surface-emitting laser array, more specifically, illustrating a step of forming a contact hole at an upper portion of a mesa, according to the first embodiment of the present disclosure.
FIG. 7 is a schematic diagram of a manufacturing process of a surface-emitting laser array, more specifically, illustrating a step of forming an upper electrode and a lower electrode, according to the first embodiment of the present disclosure.
FIG. 8 is a sectional view of a surface-emitting laser array according to a second embodiment of the present disclosure.
FIG. 9 is a plan view and B-B' sectional view of a surface-emitting laser array according to a third embodiment of the present disclosure.
FIG. 10 is a sectional view of a surface-emitting laser array according to a fourth embodiment of the present disclosure.
FIG. 11 is a schematic diagram of a spark plug provided with a surface-emitting laser array, according to a fifth embodiment of the present disclosure.

The accompanying drawings are intended to depict exemplary embodiments of the present disclosure. The accompanying drawings are not to be considered as drawn to scale unless explicitly noted.

### DETAILED DESCRIPTION

The terminology used herein is for the purpose of describing particular embodiments only and is not intended to be limiting of the present disclosure. As used herein, the singular forms "a", "an" and "the" are intended to include the plural forms as well, unless the context clearly indicates otherwise. It will be further understood that the terms "includes" and/or "including", when used in this specification, specify the presence of stated features, integers, steps, operations, elements, and/or components, but do not preclude the presence or addition of one or more other features, integers, steps, operations, elements, components, and/or groups thereof.

In describing example embodiments shown in the drawings, specific terminology is employed for the sake of clarity.

### <First Embodiment>

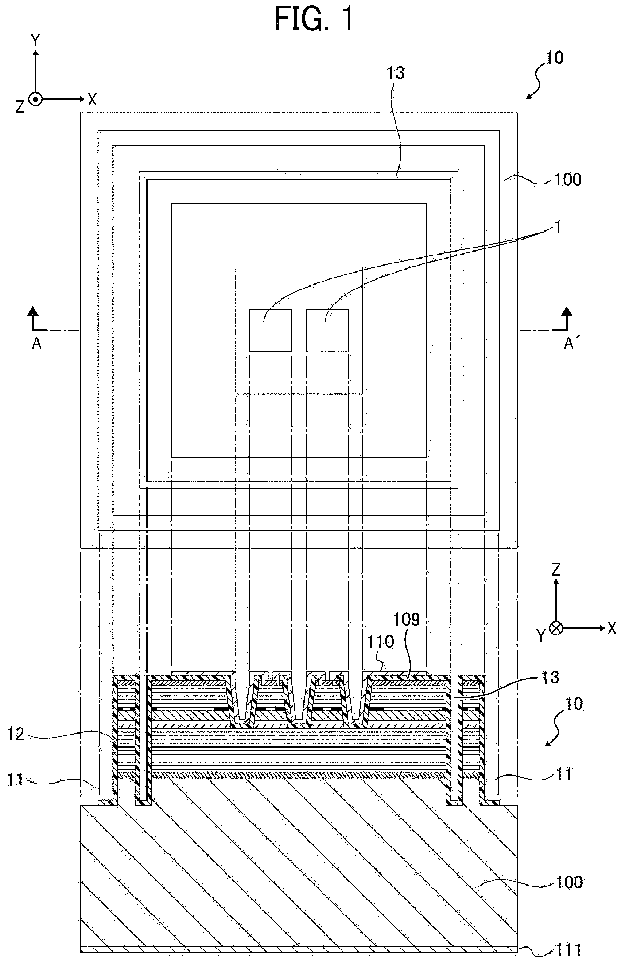

Here, a surface-emitting laser array 10 according to a first embodiment of the present disclosure is described with reference to FIG. 1 to FIG. 7.

FIG. 1 is a plan view and A-A' sectional view of a surface-emitting laser array (vertical-cavity surface-emitting laser (VCSEL) array) according to the first embodiment of the present disclosure.

In the present disclosure, the direction in which the surface-emitting laser array oscillates is referred to as the Z-direction, and directions perpendicular to each other on a plane orthogonal to the Z-direction are referred to as an X-direction and a Y-direction. In the present embodiment, the direction in which the surface-emitting laser array emits light is the +Z-direction (towards the top surface).

As illustrated in FIG. 1, the surface-emitting laser array 10 according to the first embodiment includes, for example, a plurality of light-emitting units 1 formed in an array on a substrate 100 that is parallel to an XY plane, and upper electrodes (p-side electrodes) 110 that are disposed on the multiple light-emitting units 1. For the purposes of simplification, in FIG. 1, only two light-emitting units 1 are illustrated for each of the surface-emitting laser arrays 10. However, no limitation is intended thereby. For example, three or more light-emitting units 1, or even ten thousands or more light-emitting units 1 may be formed in an array. Moreover, a conductive member such as a bonding wire that is electrically connected to wiring or the like is connected to the upper electrode 110.

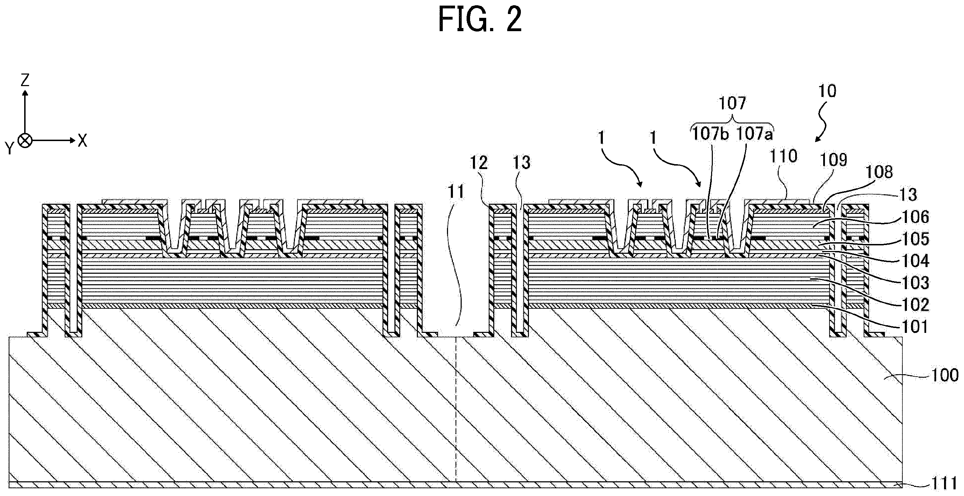

Next, the configuration of the surface-emitting laser array 10 according to the first embodiment is described with reference to FIG. 2.

FIG. 2 illustrates two surface-emitting laser arrays 10 that are adjacent to each other having a chip separation trench 11 therebetween, according to the present embodiment.

The dotted line in FIG. 2 indicates a boundary of chips to be detached from each other. The surface-emitting laser array 10 according to the first embodiment is, for example, a vertical-cavity surface-emitting laser array where the oscillation wavelength is in 808 nanometer (nm) band.

As illustrated in FIG. 2, the surface-emitting laser array 10 according to the first embodiment includes, for example, a substrate (n-GaAs substrate) 100, a buffer layer (n-buffer layer) 101, a lower semiconducting distributed Bragg reflector (DBR) (n-lower semiconducting DBR; lower reflecting mirror) 102, a lower spacer layer (n-lower spacer layer) 103, an active layer 104, an upper spacer layer (p-upper spacer layer) 105, an upper semiconductor DBR (p-upper semiconductor DBR; upper reflecting mirror) 106, a to-be-selected oxidized layer (p-oxidized layer) 107 composed of an oxidized area 107a and a non-oxidized area 107b, a contact layer (p-contact layer) 108, a dielectric film 109, an upper electrode (p-side electrode) 110, and a lower electrode (n-side electrode) 111. In the surface-emitting laser arrays 10, a plurality of chips are separated from each other via the chip separation trenches 11. Each of the surface-emitting laser array 10 has a second separation trench 13 in an inward direction from the chip separation trench 11 between a circumferential edge 12 and the light-emitting units 1.

As illustrated in the plan view of FIG. 1 according to the first embodiment, the second separation trench 13 is formed, with reference to an XY plane, in parallel to the chip separation trenches 11 and the circumferential edge 12 and in a rectangular shape so as to surround the circumference (all directions) of the light-emitting units 1. As illustrated in the sectional view of FIG. 1 and FIG. 2, the second separation trench 13 penetrates a buffer layer 101, a lower semiconducting DBR 102, a lower spacer layer 103, an active layer 104, an upper spacer layer 105, an upper semiconductor DBR 106, a to-be-selected oxidized layer 107, and a contact layer 108 in the Z-direction, and has a depth that reaches the substrate 100. In the second separation trench 13, elements from the buffer layer 101 to the contact layer 108 are completely removed, and a part of the substrate 100 is also removed.

Note also that the configuration of the second separation trench 13 is not limited to the configuration according to the first embodiment. For example, the second separation trench 13 may be formed only on one side or right and left sides of the light-emitting units 1, or may be formed so as to surround three sides of the light-emitting units 1. Alternatively, the second separation trench 13 may be inclined with reference to the circumferential edge 12. In other words, it is satisfactory as long as the second separation trench 13 is formed on at least one side that is vulnerable to physical shock in a manufacturing process such as a chip separating step and a chip conveying step.

For example, the substrate 100 is made from n-GaAs single-crystal substrate having a polished specular surface. The lower electrode 111 is a gold film that is formed on the -Z side surface of the substrate 100. Alternatively, the lower electrode 111 may be a metal film other than the gold film, or may be a multilayer film composed of a plurality of metal films.

The buffer layer 101 is composed of n-GaAs, and is stacked on the surface of the substrate 100 on the +Z side (i.e., the upper side). The lower semiconducting DBR 102 is stacked on the surface of the buffer layer 101 on the +Z side, and has two layers including aluminum with different refractive indexes, which are referred to as a "low refractive index layer" and a "high refractive index layer", respectively. More specifically, the lower semiconducting DBR 102 has 40.5 pairs of a low refractive index layer composed of n-Al_{0.9}Ga_{0.1}As and a high refractive index layer composed of n-Al_{0.3}Ga_{0.7}As.

Between two layers of varying refractive indexes, a gradient-composition layer with the thickness of 20 nm where the composition gradually changes from a side of the composition to the other side of the composition is provided in order to reduce the electrical resistance.

When it is assumed that the oscillation wavelength is λ in the present embodiment, the thickness of the low refractive index layer and the high refractive index layer is designed to include one-half of the adjacent gradient-composition layer and have an optical thickness of λ / 4. Note that when the optical thickness is λ/4, the actual thickness of the layer is D=λ/4n (where n denotes the refractive index of the medium of that layer).

The lower spacer layer 103 is stacked on the lower semiconductor DBR 102 on the +Z side, and is composed of non-doped Al_{0.6}Ga_{0.4}As. The active layer 104 is stacked on the lower spacer layer 103 on the +Z side, and has a triple-bond quantum well structure composed of Al_{0.05}Ga_{0.95}As quantum well layer/Al_{0.3}Ga_{0.7}As barrier layer. In the present embodiment, the active layer 104 is designed to have thickness such that the wavelengths of the laser beams emitted from the light-emitting units 1 are 808 nm. The upper spacer layer 105 is stacked on the active layer 104 on the +Z side, and is composed of non-doped Al_{0.6}Ga_{0.4}As.

The portion consisting of the lower spacer layer 103, the active layer 104, and the upper spacer layer 105 is referred to as a resonator structure, and is designed to include one-half of the adjacent gradient-composition layer and have the optical thickness of one wavelength (λ). The active layer 104 is disposed in the center of the resonator structure so as to achieve a high stimulated-emission rate. Note that the center of the resonator structure corresponds to a belly of the standing-wave distribution of the electric field.

The upper semiconductor DBR 106 is stacked on the upper spacer layer 105 on the +Z side, and includes twenty-five pairs of a low refractive index layer composed of p-Al_{0.9}Ga_{0.1}As and a high refractive index layer composed of p-Al_{0.3}Ga_{0.7}As. Between two layers of varying refractive indexes of the upper semiconductor DBR 106, a gradient-composition layer where the composition gradually changes from a side of the composition to the other side of the composition is provided in order to reduce the electrical resistance. Each of the layers of varying refractive indexes is designed to include one-half of the adjacent gradient-composition layer and have an optical thickness of λ/4.

One of the low refractive index layers of the upper semiconductor DBR 106 includes an inserted to-be-selected oxidized layer (electric current narrow layer) 107 composed of AlAs. The to-be-selected oxidized layer 107 is formed by selectively oxidizing one of the low refractive index layers of the upper semiconductor DBR 106. In such selective oxidization is performed from a side of the low refractive index layer, and aluminum (Al) is oxidized. The to-be-selected oxidized layer 107 composed of the oxidized area 107a and the non-oxidized area 107b.

The contact layer 108 is stacked on the upper semiconductor DBR 106 on the +Z side, and is composed of p-GaAs. On the +Z-side of the contact layer 108, the dielectric film 109 that is made of p-SiN and is optically transparent is laminated. Note also that the dielectric film 109 is formed by plasma chemical-vapor deposition (CVD), and that the dielectric film 109 is laminated all over the inner surface of the second separation trenches 13. Moreover, a part of the upper electrode 110, which is insulated by the dielectric film 109, contacts or is connected to the contact layer 108. In the present embodiment, the upper electrode 110 is made of gold.

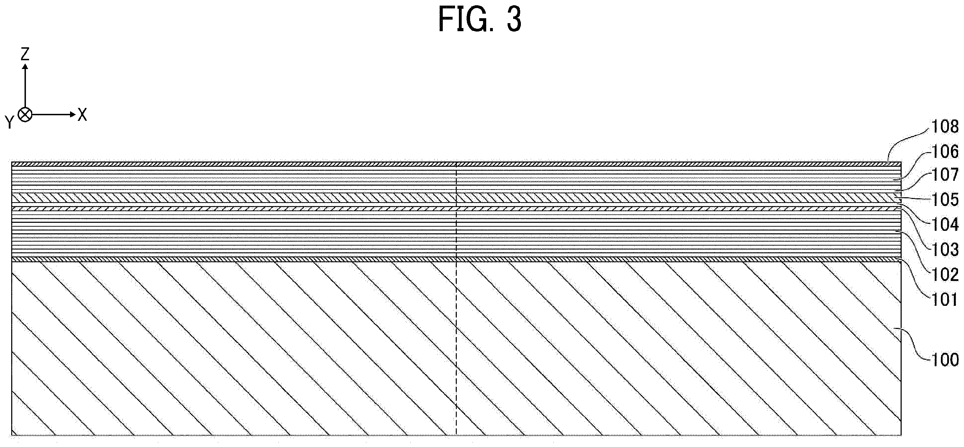

Next, a method of manufacturing the surface-emitting laser array 10 according to the first embodiment is described with reference to FIG. 3 to FIG. 7.

FIG. 3 to FIG. 7 illustrate steps of manufacturing the surface-emitting laser array 10 according to the present embodiment.

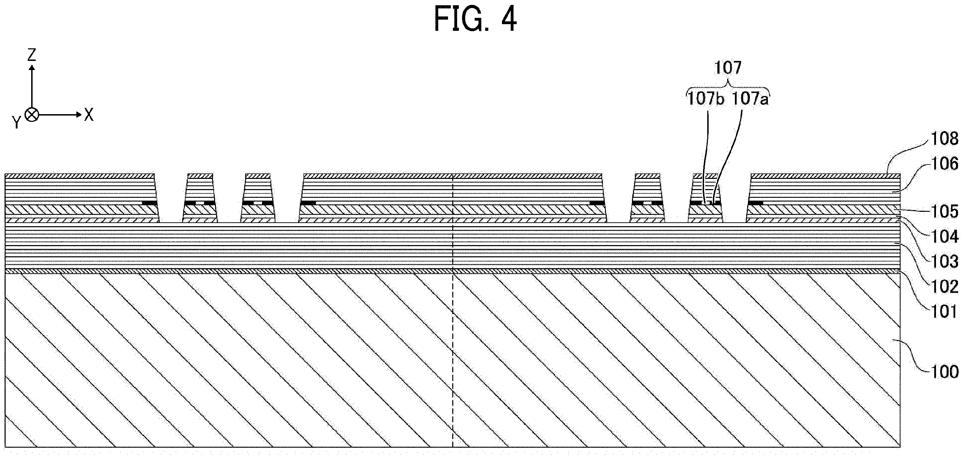

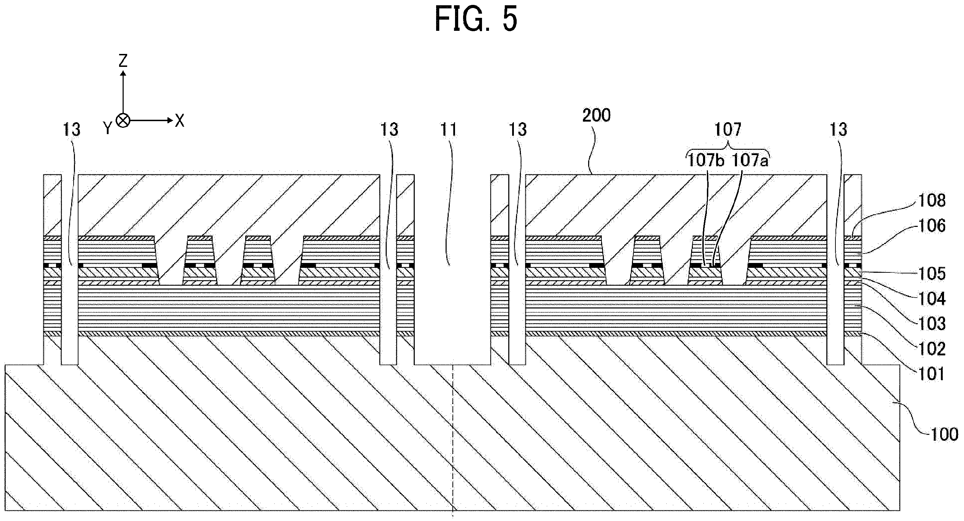

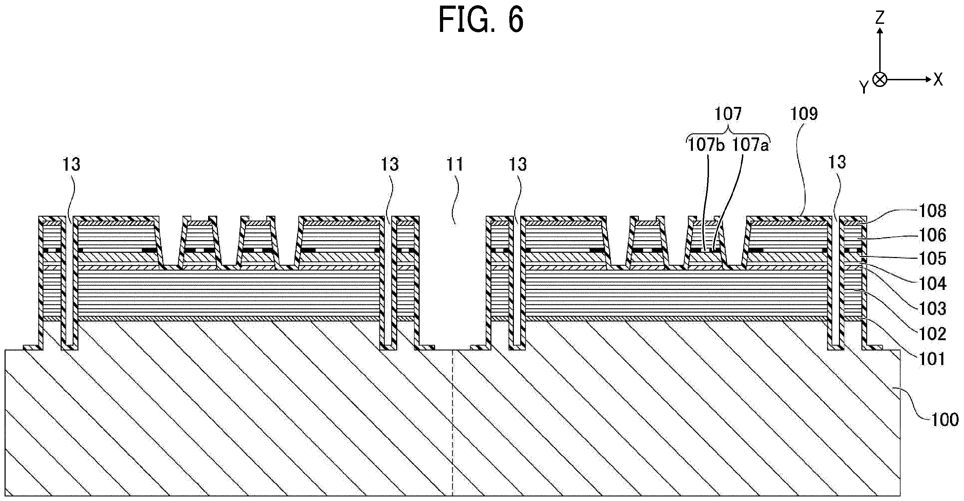

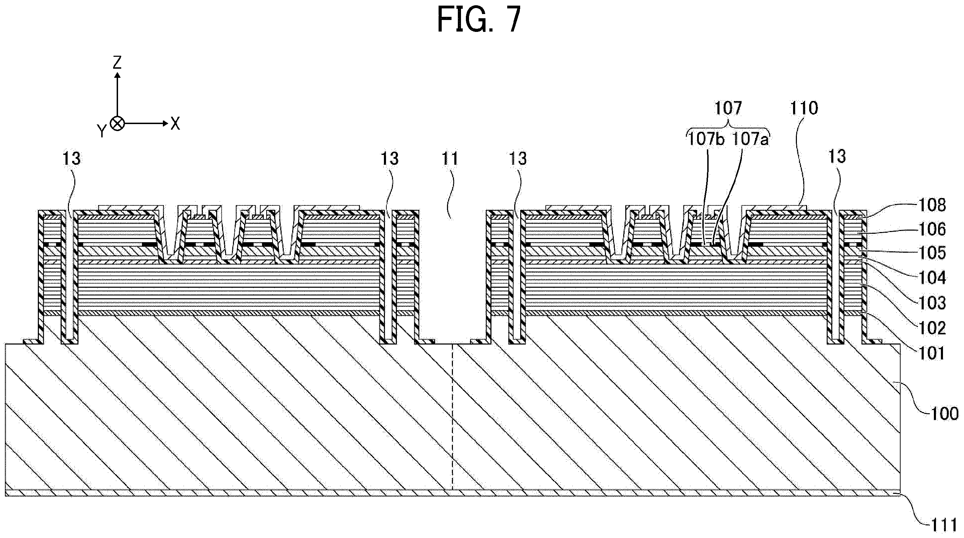

In the steps of manufacturing a semiconductor, firstly, a plurality of surface-emitting laser arrays 10 are integrally formed at the same time, and then are divided into a plurality of chips of the surface-emitting laser arrays 10. Note that in the following description, the product of a plurality of semi-conducting layers stacked on the substrate 100 as described above may be referred to simply as a layered product. Each of the surface-emitting laser arrays 10 may also be referred to as a "chip".
(1) The layered product as described above is formed on the substrate 100 composed of n-GaAs by crystal growth using the metal-organic chemical vapor deposition (MOCVD) or the molecular beam epitaxy (MBE). Such crystal growth is performed inside the reaction tube of a crystal growth device.
   In the present embodiment, an example where metal-organic chemical vapor deposition (MOCVD) is used is described. In the MOCVD, trimethylaluminum (TMA), trimethylgallium (TMG), and trimethylindium (TMI) are used as a group III material, and arsine (AsH₃) are used as a group V material. Moreover, carbon tetrabromide (CBr₄) is used as a p-type dopant material, and hydrogen selenide (H₂Se) is used as a n-type dopant material.
   More specifically, the buffer layer 101, the lower semiconducting DBR 102, the lower spacer layer 103, the active layer 104, the upper spacer layer 105, the upper semiconductor DBR 106 including the to-be-selected oxidized layer 107, and the contact layer 108 are grown on the substrate 100 in that order to form a layered product (see FIG. 3).
(2) On the surface of the layered product, a square-shaped resist pattern in a desired mesa shape with the sides of 25 micrometers (µm) is formed in an array by lithography. In the present embodiment, a resist pattern is formed beyond an area corresponding to the upper electrode 110 that is formed in a later step.
(3) The inductively coupled plasma (ICP) dry etching is adopted, and a plurality of quadrangular-prism mesas (mesa structure) are formed in an array using the above-described resist pattern as a photomask. Then, the resist pattern is removed.
(4) The layered product in which the mesas are formed is heated up in the vapor to oxidize the layered product. In the present embodiment, aluminum (Al) in a to-be-selected oxidized layer 107 is selectively oxidized from the periphery of the mesa. Then, a non-oxidized area 107b that is surrounded by an oxidized area 107a of Al is left non-oxidized in the center of the mesa (see FIG. 4). In the to-be-selected oxidized layer 107, the oxidized area (insulating layer) 107a forms an oxidation constriction structure that limits the path of the driving current of the light-emitting units 1 only to the center of the mesa. The non-oxidized area 107b may be referred to as a current-carrying area (current injection area). Note also that the to-be-selected oxidized layer 107 may be referred to as an electric current narrow layer. Due to the steps as described above, for example, an approximately square-shaped current-carrying area with the width of about 4 µm to 6 µm is formed.
(5) In the layered product for which oxidization has been completed, a resist pattern 200 is formed by photolithography such that only an area for the chip separation trench 11 and an area for the second separation trench 13 on the inner side of the chip separation trench 11 are exposed to outside. After the chip separation trench 11 is formed and the second separation trenches 13 are formed on the inner side of the chip separation trench 11 using inductively coupled plasma (ICP) dry etching, the resist pattern is removed. In so doing, etching is performed until the etching reaches the depth of about 1 µm of the substrate 100 (see FIG. 5).
(6) The layered product for which the mesas, the chip separation trench 11, and the second separation trenches 13 have been formed is placed in the heating chamber, and is kept in nitrogen atmosphere for three minutes at temperatures ranging from 380°C through 400°C. By so doing, oxygen or water that sticks to the surface in the atmosphere or a natural oxide film that is formed by a trace quantity of oxygen or water in the heating chamber is heated in the nitrogen atmosphere and becomes a stable passivation coating. This step in (6) is not essential and may be omitted.
(7) The chemical-vapor deposition (CVD) is used to form the dielectric film 109 made of p-SiN, SiON, or SiO₂ (see FIG. 6). In so doing, the dielectric film 109 is also formed on sides of the lower semiconducting DBR 102, the upper semiconductor DBR 106, and the active layer 104. Accordingly, the dielectric film 109 is also formed on the wall and base of the chip separation trench 11 and the wall and base of the second separation trench 13, and the shock resistance and waterproofness further improves. However, such formation is not always necessary.
   It is desired that the thickness of the dielectric film 109 fall within the ranging from 100 nanometers (nm) to 400 nm. When the dielectric film 109 is thinner than 100 nm, the wiring capacity increases, and the speed of operation decreases. When the dielectric film 109 is thicker than 400 nm, crystal defects may be caused due to the internal stress of the dielectric film 109. It is further desirable for the dielectric film 109 to have thickness of 150 nm to 300 nm, and in the present embodiment, the p-SiN film is formed with the thickness of 200 nm by the plasma CVD.
(8) A slot for the p-side electrode contact is made at an upper part of each mesa. In other words, a contact hole is formed on the top surface of the mesa, i.e., on the dielectric film 109. In the present embodiment, an etching mask is formed using photoresist, and then an upper part of the mesa is exposed to light to remove the exposed portion of the photoresist. Further, wet etching is performed on the dielectric film 109 using buffered hydrofluoric acid (BHF) to form a slot (i.e., contact hole). At the same time, the dielectric film 109 at the bottom of the chip separation trench 11, which is formed in the step of (5) as above, is also removed for scribing or dicing (see FIG. 6).
(9) The photoresist (lift-off resist) is patterned using photolithography, and the p-side electrode material is evaporated. More specifically, a square-shaped resist pattern with the sizes of 10 µm that serves as a light-exiting portion surrounded by a p-side electrode at the top of the mesa, and resist patterns that serve as a plurality of electrode pads, which are connected to the light-emitting unit 1 are formed. Then, the films of the p-side electrode material are formed by electron-beam vapor deposition. The p-side electrode material may be a multilayer film composed of Ti/Pt/Au.
(10) The electrode material of a light-exiting portion (exit area) is lifted off, and an upper electrode (p-side electrode) 110 is formed.
(11) The lower electrode (n-side electrode) 111 is evaporated onto the -Z side surface (back side) of the substrate 100. In the present embodiment, the lower electrode 111 is a multilayer film composed of AuGe/Ni/Au (see FIG. 7 for the above processes).
(12) Heating is performed for four minutes with 400°C in N₂ atmosphere, and ohmic contact between the electrode material and the semiconductor is achieved.
(13) The layered product is cut into chips using a scribe and brake method or dicing.

Due to the steps in (1) to (13) as described above, the surface-emitting laser array 10 according to the first embodiment of the present disclosure, as illustrated in FIG. 1, can be obtained.

As described above, in the surface-emitting laser array 10 according to the first embodiment, even when an outermost part of a chip is physically shocked in the manufacturing process (e.g., transportation of chips) and the dielectric film 109 on the side of the chip separation trench 11 is damaged, due to the second separation trenches 13 that are internally provided, the semiconductor layered product of multilayers are not exposed to moisture in the environment over the second separation trenches 13. Accordingly, the surface-emitting laser array 10 with good quality and reliability on a long-term basis can be provided.

In the surface-emitting laser array 10 according to the first embodiment, the upper semiconductor DBR 106, the active layer 104, and the lower semiconducting DBR 102 are completely removed from the second separation trenches 13, and has a depth that reaches the substrate 100. Due to this configuration, even when microcracks are developed on the surface of the dielectric film 109 on the sides of the chip separation trench 11, the intrusion of moisture into a light-emitting area of the layered product can further be prevented, and reliability is achieved on a long-term basis.

In the surface-emitting laser array 10 according to the first embodiment, the dielectric film 109 is also formed on the two walls of the circumferential edge 12 and on the wall of the second separation trench 13 on the light-emitting units 1 side. Note that it is satisfactory as long as the dielectric film 109 is formed, at least, on the wall of the second separation trench 13 on the light-emitting units 1 side. Due to the dielectric film 109, the second separation trench 13 can serve as a barrier to moisture more efficiently, and the reliability further improves on a long-term basis.

In the first embodiment, the dielectric film 109 is a silicon nitride film (SiN), and the upper electrode 110 and the lower electrode 111 are made from a gold film. Due to this configuration, formation is relatively easy with known plasma-enhanced chemical vapor deposition (plasma CVD) and electron-beam vapor deposition.

### <Second Embodiment>

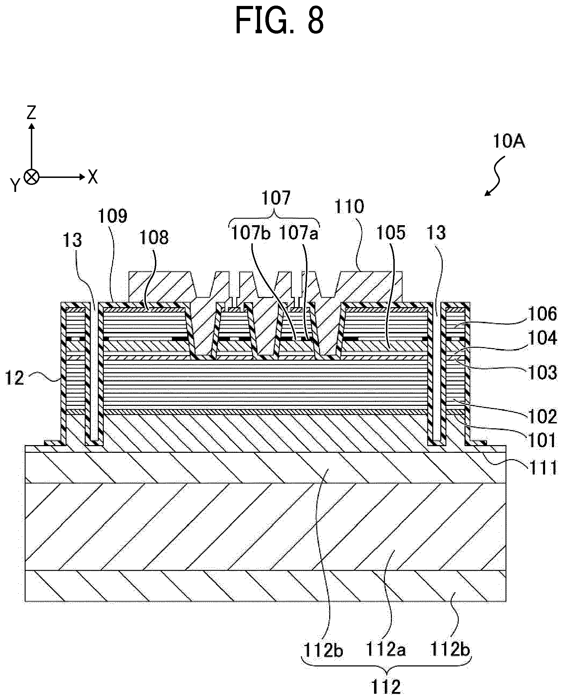

Next, a surface-emitting laser array 10A according to a second embodiment of the present disclosure is described with reference to FIG. 8.

FIG. 8 is a sectional view of the surface-emitting laser array 10A according to the second embodiment of the present disclosure.

Note that the basic configuration of the surface-emitting laser array 10A according to the second embodiment is similar to that of the surface-emitting laser array 10 according to the first embodiment. For this reason, like reference signs are given to elements similar to those described in the first embodiment, and their detailed description is omitted. In the following description, configurations that are different from those described in the first embodiment are mainly described. The same goes for the embodiments as will be described later.

In the surface-emitting laser array 10 according to the first embodiment as described above, the lower electrode 111 is formed on the -Z side surface (back side) of the substrate 100. By contrast, in the surface-emitting laser array 10A according to the second embodiment, as illustrated in FIG. 8, the substrate 100 is removed, and the lower electrode 111 is formed so as to contact the buffer layer 101. Further, the lower electrode 111 may be bonded to a thermal diffusion board 112. For example, it is desired that a material where Cu films 112b are formed on both sides of an aluminum nitride (AlN) board 112a to reduce the differences in thermal expansion coefficient with GaAs be used for the thermal diffusion board 112. In this configuration, the heat that is generated at the active layer 104 can efficiently be dissipated. For this reason, the surface-emitting laser array 10A according to the second embodiment is suitable for a device where the surface-emitting laser arrays 10A are integrated on a large scale and the output power exceeds 100 watts (W).

### <Third Embodiment>

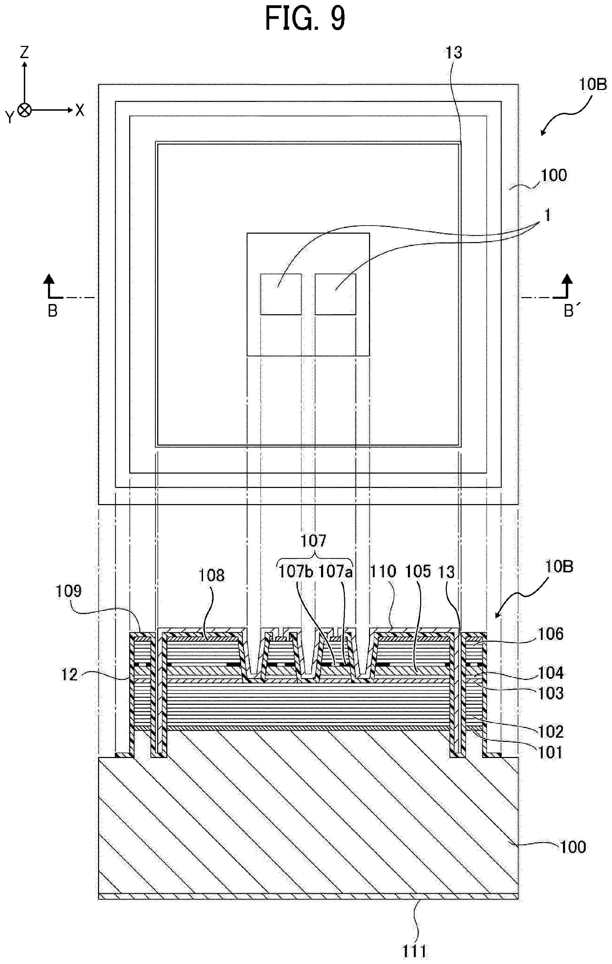

Next, a surface-emitting laser array 10B according to a third embodiment of the present disclosure is described with reference to FIG. 9.

FIG. 9 is a plan view and B-B' sectional view of the surface-emitting laser array 10B according to the third embodiment of the present disclosure.

As illustrated in FIG. 9, the surface-emitting laser array 10B according to the third embodiment has a basic configuration similar to that of the surface-emitting laser array 10 according to the first embodiment. The difference is in that the upper electrode (p-side electrode) 110 is disposed on the wall of the second separation trench 13. More specifically, the upper electrode 110 is disposed on one side of the wall of the second separation trench 13.

In order to manufacture the surface-emitting laser array 10B of the configuration as described above, the upper electrode (p-side electrode) 110, which is described above in the step (9) of the first embodiment, is formed so as to cover the wall of the second separation trench 13, at least, on the light-emitting units 1 side, as illustrated in FIG. 9. However, no limitation is intended thereby. The upper electrode (p-side electrode) 110 may cover the bottoms of the second separation trenches 13 or even the wall of the second separation trenches 13 on the circumferential edge 12 side.

In the surface-emitting laser array 10B according to the third embodiment, when an outermost part of a chip is physically damaged in the manufacturing process (e.g., transportation of chips) and the dielectric film 109 on the side of the chip separation trench 11 is damaged, the intrusion of moisture can well be prevented. In addition to that, the surface-emitting laser array 10B according to the third embodiment may have a metal film (gold film) made of the upper electrode 110 on the wall of the second separation trenches 13 over the dielectric film 109. Accordingly, even when microcracks are developed on a thin film during a dielectric film forming process, the semiconductor layered product of multilayer film can be prevented from being exposed to the environmental moisture beyond the second separation trench 13. Accordingly, the surface-emitting laser array 10B with good quality and reliability on a long-term basis can be provided.

### <Fourth Embodiment>

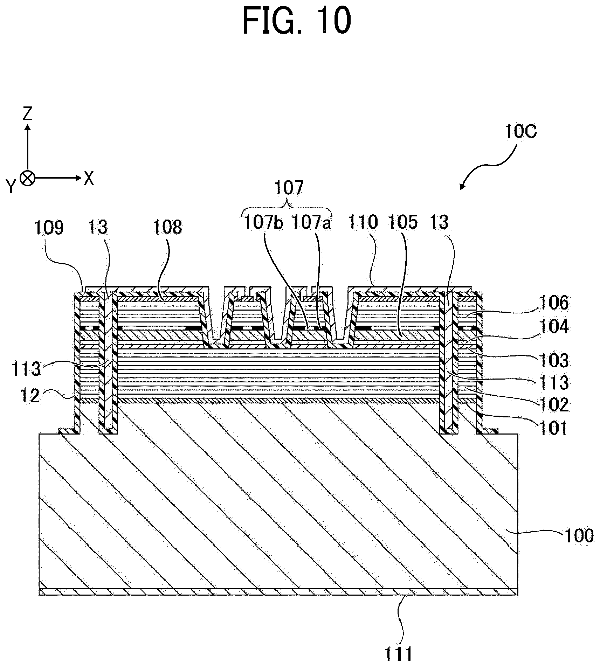

Next, a surface-emitting laser array 10C according to a fourth embodiment of the present disclosure is described with reference to FIG. 10.

FIG. 10 is a sectional view of the surface-emitting laser array 10C according to the fourth embodiment of the present disclosure.

Note that as illustrated in FIG. 10, the basic configuration of the surface-emitting laser array 10C according to the fourth embodiment is similar to that of the surface-emitting laser array 10 according to the first embodiment. The difference is in that the second separation trench 13 includes a filling material 113 therein.

In the fourth embodiment, the filling material 113 fills the entirety of the second separation trench 13. However, no limitation is intended thereby. It is satisfactory as long as the filling material 113 fills at least some of the second separation trench 13. In the fourth embodiment, the filling material 113 is made of polyimide. However, no limitation is intended thereby, and any other materials may be used as long as the intrusion of moisture can be prevented.

In order to manufacture the surface-emitting laser array 10C of the configuration as described above, after the step of (7) according to the first embodiment as described above, spin coating is performed with photosensitive polyimide. In order to expose areas other than the second separation trenches 13, exposure is performed upon forming photoresists only on the second separation trenches 13. Then, the polyimide at areas other than the second separation trenches 13 are removed by performing development. After the photoresists are removed, imidization is performed with heating to 400°C. Subsequently, the steps of (8) to (13) according to the first embodiment as described above are performed. Accordingly, the surface-emitting laser array 10C according to the fourth embodiment can be obtained. Note also that in the present embodiment, the top surfaces of the second separation trenches 13 and outer portions beyond the top surfaces of the second separation trenches 13 are coated by the upper electrode 110. Accordingly, the strength against shock or the like further improves.

In the surface-emitting laser array 10C according to the fourth embodiment, when an outermost part of a chip is physically damaged in the manufacturing process (e.g., transportation of chips) and the dielectric film 109 on the side of the chip separation trench 11 is damaged, the intrusion of moisture can well be prevented. In addition to that, the second separation trench 13 is filled with the filling material 113. Accordingly, even when microcracks are developed on a thin film during a dielectric film forming process, the semiconductor layered product of multilayer film can be prevented from being exposed to the environmental moisture beyond the second separation trench 13. Accordingly, the surface-emitting laser array 10C with good quality and reliability on a long-term basis can be provided.

### <Fifth Embodiment>

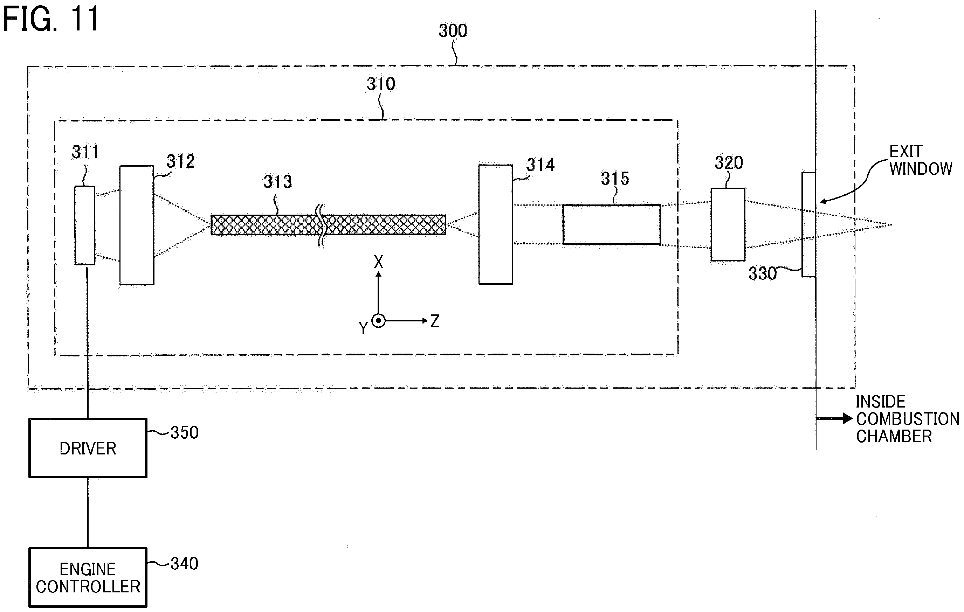

Next, an ignition system 300 is described with reference to FIG. 11 as an example of a laser device that is provided with the surface-emitting laser array according to the embodiments of the present disclosure.

FIG. 11 is a schematic diagram of a laser device (spark plug) provided with a surface-emitting laser array, according to the fifth embodiment of the present disclosure.

In the fifth embodiment, an example of an ignition system for an engine (internal combustion engine) that includes a fuel injector, an exhauster, a combustion chamber, and a piston is described. The engine may be, for example, a piston engine, a rotary engine, a gas turbine engine, and a jet engine.

As illustrated in FIG. 11, the ignition system 300 according to the fifth embodiment includes, for example, a laser module 310, an emission optical system 320, and a protector 330. The ignition system 300 is controlled and driven by an engine controller 340.

The emission optical system 320 collects and condenses the light emitted from laser module 310. Accordingly, a high energy density can be obtained at a focal point. The protector 330 is a transparent window facing towards the combustion chamber, and is made from, for example, sapphire glass.

The laser module 310 includes a surface-emitting laser array 311, a first condensing optical system 312, an optical fiber 313, a second condensing optical system 314, and a laser resonator 315. The surface-emitting laser array 311 may be, for example, the surface-emitting laser arrays 10, 10A, 10B, and 10C according to the first to fourth embodiments of the present disclosure. The surface-emitting laser array 311 is driven by a driver 350.

In the ignition system 300 as configured above according to the fifth embodiment, the driver 350 drives the surface-emitting laser array 311 based on an instruction from the engine controller 340. More specifically, the driver 350 drives the surface-emitting laser array 311 such that the ignition system 300 emits light at the timing when the engine performs ignition. Note that a plurality of light-emitting units of the surface-emitting laser array 311 are switched on and switched off at the same time.

The light (laser beam) that is emitted from the surface-emitting laser array 311 is collected and condensed by the first condensing optical system 312, and enters the optical fiber 313. The light that has entered the optical fiber 313 propagates through the core, and is exited from the +Z side lateral edge face of the core. The light that is emitted from the optical fiber 313 is collected and condensed by the second condensing optical system 314 that is disposed in the optical path of the light, and enters the laser resonator 315. The light is resonated and amplified by the laser resonator 315, and the light is exited towards the emission optical system 320.

The emission optical system 320 collects and condenses the light emitted from laser module 310. Then, the light passes through the protector 330, and is exited inside the combustion chamber. Accordingly, the fuel is ignited.

As described above, for example, the surface-emitting laser arrays 10, 10A, 10B, and 10C according to the first to fourth embodiments of the present disclosure is used in the fifth embodiment. Accordingly, the influence of moisture can be controlled, and the ignition system 300 with good quality and reliability on a long-term basis can be provided.

Note that the laser device according to an embodiment of the present disclosure is not limited to the ignition system 300 according to the fifth embodiment. For example, the laser device according to an embodiment of the present disclosure may be, for example, a laser peening device, a laser terahertz generator, a laser display device, and a laser beam machine such as a laser annealing device. Such laser devices are provided with, for example, the surface-emitting laser arrays 10, 10A, 10B, and 10C according to the first to fourth embodiments of the present disclosure, or a laser module including the surface-emitting laser arrays 10, 10A, 10B, and 10C according to the first to fourth embodiments. Accordingly, even when these laser devices are physically shocked, the intrusion of moisture or the like into the semi-conducting layer can be prevented. Thus, the laser devices with good quality and reliability on a long-term basis can be provided. The surface-emitting laser arrays 10, 10A, 10B, and 10C according to the first to fourth embodiments of the present disclosure, a laser module including the surface-emitting laser arrays 10, 10A, 10B, and 10C according to the first to fourth embodiments, or the like may be used for writing operation or the like in multifunction peripherals (MFP), and a similar effect can be achieved thereby.

## Claims

1. A surface-emitting laser array (10, 10A, 10B, 10C) comprising a plurality of light-emitting units (1) formed on a substrate (100) and within a layered product,
said layered product including
a lower reflecting mirror (102) having two layers with different refractive indexes,
an upper reflecting mirror (106), and
an active layer (104) disposed between the lower reflecting mirror (102) and the upper reflecting mirror (106); the laser array further comprising:
a first separation trench (11) from which the upper reflecting mirror (106), the active layer (104), and the lower reflecting mirror (102) are removed, the first separation trench (11) separating the surface-emitting laser array (10, 10A, 10B, 10C) from an adjacent chip (10, 10A, 10B, 10C); and
a second separation trench (13) disposed between the first separation trench (11) and a light-emitting unit (1) that emits a laser beam, the second separation trench (13) having a prescribed depth;
**characterized in that** the second separation trench (13) has a depth that passes through the upper reflecting mirror (106), the active layer (104), and the lower reflecting mirror (102), so that the second separation trench reaches the substrate (100).

2. The surface-emitting laser array (10, 10A, 10B, 10C) according to claim 1, wherein the second separation trench (13) has a dielectric film (109) on at least some of a wall of the second separation trench (13).

3. The surface-emitting laser array (10, 10A, 10B, 10C) according to claim 2, wherein the second separation trench (13) has a metal film disposed on at least some of the wall of the second separation trench (13) having the dielectric film (109) between the metal film and the wall of the second separation trench (13).

4. The surface-emitting laser array (10, 10A, 10B, 10C) according to claim 3, wherein
the dielectric film (109) is a silicon nitride film, and
the metal film is a gold film.

5. The surface-emitting laser array (10, 10A, 10B, 10C) according to any one of claims 1 or 2, wherein the second separation trench (13) includes, at least partially, a filling material (113).

6. A laser device (300) comprising: the surface-emitting laser array (10, 10A, 10B, 10C) according to any one of claims 1 to 5.

## Patentansprüche

1. Oberflächenemittierende Laseranordnung (10, 10A, 10B, 10C), die eine Vielzahl von Lichtemissionseinheiten (1) umfasst, die auf einem Substrat (100) und innerhalb eines Schichtprodukts gebildet sind,
wobei das Schichtprodukt Folgendes umfasst:
einen unteren reflektierenden Spiegel (102), der zwei Schichten mit unterschiedlichen Brechungsindizes aufweist,
einen oberen reflektierenden Spiegel (106) und
eine aktive Schicht (104), die zwischen dem unteren reflektierenden Spiegel (102) und dem oberen reflektierenden Spiegel (106) angeordnet ist;
wobei die Laseranordnung ferner Folgendes umfasst:
einen ersten Trenngraben (11), von dem der obere reflektierende Spiegel (106), die aktive Schicht (104) und der untere reflektierende Spiegel (102) entfernt sind, wobei der erste Trenngraben (11) die oberflächenemittierende Laseranordnung (10, 10A, 10B, 10C) von einem benachbarten Chip (10, 10A, 10B, 10C) trennt; und
einen zweiten Trenngraben (13), der zwischen dem ersten Trenngraben (11) und einer Lichtemissionseinheit (1) angeordnet ist, die einen Laserstrahl emittiert, wobei der zweite Trenngraben (13) eine vorgeschriebene Tiefe hat;
**dadurch gekennzeichnet, dass** der zweite Trenngraben (13) eine Tiefe aufweist, die durch den oberen reflektierenden Spiegel (106), die aktive Schicht (104) und den unteren reflektierenden Spiegel (102) verläuft, damit der zweite Trenngraben das Substrat (100) erreicht.

2. Oberflächenemittierende Laseranordnung (10, 10A, 10B, 10C) nach Anspruch 1, wobei der zweite Trenngraben (13) einen dielektrischen Film (109) auf mindestens einem Teil einer Wand des zweiten Trenngrabens (13) aufweist.

3. Oberflächenemittierende Laseranordnung (10, 10A, 10B, 10C) nach Anspruch 2, wobei der zweite Trenngraben (13) einen Metallfilm aufweist, der auf mindestens einem Teil der Wand des zweiten Trenngrabens (13) angeordnet ist, der den dielektrischen Film (109) zwischen dem Metallfilm und der Wand des zweiten Trenngrabens (13) aufweist.

4. Oberflächenemittierende Laseranordnung (10, 10A, 10B, 10C) nach Anspruch 3, wobei der dielektrische Film (109) ein Siliziumnitridfilm ist und der Metallfilm ein Goldfilm ist.

5. Oberflächenemittierende Laseranordnung (10, 10A, 10B, 10C) nach einem der Ansprüche 1 oder 2, wobei der zweite Trenngraben (13) zumindest teilweise ein Füllmaterial (113) enthält.

6. Laservorrichtung (300), die Folgendes umfasst: die oberflächenemittierende Laseranordnung (10, 10A, 10B, 10C) nach einem der Ansprüche 1 bis 5.

## Revendications

1. Réseau laser à émission par la surface (10, 10A, 10B, 10C) comprenant une pluralité d'unités électroluminescentes (1) formées sur un substrat (100) et à l'intérieur d'un produit stratifié,
ledit produit stratifié comprenant
un miroir réfléchissant inférieur (102) présentant deux couches avec différents indices de réfraction,
un miroir réfléchissant supérieur (106), et
une couche active (104) disposée entre le miroir réfléchissant inférieur (102) et le miroir réfléchissant supérieur (106) ;
le réseau laser comprenant en outre :
une première tranchée de séparation (11) dont le miroir réfléchissant supérieur (106), la couche active (104) et le miroir réfléchissant inférieur (102) sont retirés, la première tranchée de séparation (11) séparant le réseau laser à émission par la surface (10, 10A, 10B, 10C) d'une puce adjacente (10, 10A, 10B, 10C) ; et
une deuxième tranchée de séparation (13) disposée entre la première tranchée de séparation (11) et une unité électroluminescente (1) qui émet un faisceau laser, la deuxième tranchée de séparation (13) présentant une profondeur prescrite ;
**caractérisé en ce que** la deuxième tranchée de séparation (13) présente une profondeur qui passe par le miroir réfléchissant supérieur (106), la couche active (104) et le miroir réfléchissant inférieur (102), de manière que la deuxième tranchée de séparation atteint le substrat (100).

2. Réseau laser à émission par la surface (10, 10A, 10B, 10C) selon la revendication 1, dans lequel la deuxième tranchée de séparation (13) comporte un film diélectrique (109) sur au moins une partie d'une paroi de la deuxième tranchée de séparation (13).

3. Réseau laser à émission par la surface (10, 10A, 10B, 10C) selon la revendication 2, dans lequel la deuxième tranchée de séparation (13) comporte un film métallique disposé sur au moins une partie de la paroi de la deuxième tranchée de séparation (13) comportant un film diélectrique (109) entre le film métallique et la paroi de la deuxième tranchée de séparation (13).

4. Réseau laser à émission par la surface (10, 10A, 10B, 10C) selon la revendication 3, dans lequel
le film diélectrique (109) est un film de nitrure de silicium, et
le film métallique est un film en or.

5. Réseau laser à émission par la surface (10, 10A, 10B, 10C) selon l'une quelconque des revendications 1 ou 2, dans lequel la deuxième tranchée de séparation (13) comprend, au moins partiellement, un matériau de remplissage (113).

6. Dispositif laser (300) comprenant : le réseau laser à émission par la surface (10, 10A, 10B, 10C) selon l'une quelconque des revendications 1 à 5.
